# EUROPEAN PATENT APPLICATION

(11) **EP 0 604 809 A2**
(43) Date of publication of application: **06.07.1994**
(21) Application number: 93120007.5
(22) Date of filing: 11.12.1993
(51) Int. Cl.: G01R 33/04

(54) **Magnetic field sensor device**

(30) Priority: 31.12.1992 ES 9202675
(71) Applicant: ALCATEL STANDARD ELECTRICA, S.A., ES-28045 Madrid (ES)
(72) Inventor: Tamayo Lopez, Braulio, E-28109 El Soto - Alcobendas (Madrid) (ES); Hernandez Carbonero, Miguel, E-28007 Madrid (ES); Sempere Hernandez, Francisco, E-28026 Madrid (ES); Aroca Hernandez-Ros, Claudio, E-28008 Madrid (ES); Sanchez Trujillo, Carmen, E-28220 Majadahonda (Madrid) (ES); Lopez Perez, Eloisa, E-28003 Madrid (ES); Sanchez Sanchez, Pedro, E-28043 Madrid (ES)
(74) Representative: Pohl, Herbert, Dipl.-Ing

(57) **Abstract**

Of the type based on flux-gate technology and second harmonic detection, that comprises a master oscillator (1) used as reference in a generator (2) to generate two signals of basic operating frequency and of double frequency respectively. The first one is amplified in a power booster (3) in order to energise the magnetising coil in the sensor head (4).

The output signal from the sensor head is filtered in a bandpass filter (5), the output signal of which is detected in a phase detector (6) that is connected to a lowpass filter (7).

It also incorporates a communications block (8) and a self-calibration block (9) for the transmission of data to a remote station, and for calibration and checking also from a remote station.

## Description

### OBJECT OF THE INVENTION

This invention concerns a high sensitivity magnetic field sensor device, based on the flux-gate technology, for measurements of magnetic fields over a wide dynamic range and within a broad range of temperature.

### BACKGROUND TO THE INVENTION

The operating principle of a flux-gate sensor has been well known for many years. It is based on a core of ferromagnetic material on which is wound a magnetising coil in order to magnetically saturate the core, and a sensor coil that detects the changes in magnetic permeability of the core resulting from asymmetry in the hysteresis characteristic of the core when there is another magnetic field produced externally to said core.

In the article "The Fluxgate Magnetometer" by F. Primdahl, published in the J. Phys. E: Sci. Instrum., vol. 12, 1979, figure 11 shows a block diagram of an electronic circuit for magnetic field measurements based on the flux-gate principle, which is also explained in section 10.

In this article, two signals are obtained with angular frequencies w and 2w respectively, by dividing the output from a master oscillator. The first signal, at frequency w, is amplified and applied to the magnetising coil, creating a magnetic field that saturates the core and that is coupled into the sensor coil. Subsequently the signal detected by the sensor coil is filtered at the angular frequency of 2w by means of a bandpass filter and, afterwards, its amplitude is detected by means of a phase detector taking into account the coherence of the two signals of frequency 2w that are applied to this detector.

The output signal of the phase detector mentioned is first filtered and amplified before being fed back to a field compensating coil which has the effect of cancelling the second harmonic of the signal detected by the sensor coil. In this way, the output voltage is proportional to the cancelled magnetic field that corresponds to the external magnetic field created inside the core. This operating procedure is called the zero method.

In order to obtain a high sensitivity, the bandwidth of the bandpass filter (with central frequency 2w), that is to be found at the output of the sensor coil, has to be very narrow in order to leave only the useful signal, suppressing noise and harmonics of the basic operating frequency.

As a consequence of this, the component values employed in certain parts of this circuit are very critical and the drift in these due to aging or temperature changes, etc., make their use unfeasible in some kinds of application.

### TECHNICAL PROBLEM TO BE OVERCAME

One of the technical problems to overcome lies in how to make the characteristics of the critical functions of the filters and phase shifters independent of the aforementioned parameters of temperature, aging, humidity, etc., such that their operation continues to be correct under extreme environmental conditions.

Another problem is that when the magnetic fields that it is desired to detect are very weak, the actual magnetic field of the Earth masks them, making their detection therefore impossible.

### CHARACTERISATION OF THE INVENTION

The above mentioned problems are solved by means of the device in accordance with the invention in which the characteristics of all the filtering and phase-shifting operations of the circuit commonly used, of the type described above, are made to depend on a common single reference frequency for the signals processed, such that their relative variations are always zero.

Use is also made of an amplifier with a current mode output for the amplification of the signal with angular frequency w that is applied to the magnetising coil, such that no relative phase variations occur in the signal path before the input to the phase detector.

The device of the invention also has a self-calibration block that receives the output signal of the detected field and that feeds the compensating coil, thereby cancelling the Earth's magnetic field inside the core and, from that moment, maintaining a current flow in this compensating coil so that other much weaker magnetic fields can be detected.

The device also has a communications block for sending the output signal information from the detector to a remote point, as well as for receiving feeding current and control commands from the same remote point.

These control commands permit the self-calibration to be done as well as self-testing. This is all carried out by the self-calibration block itself. It consists of changing the compensating coil current by a certain amount, obtaining in this way an output signal with a value that depends on this change in current and that thereby serves to check the device is operating properly.

### BRIEF FOOTNOTES TO THE FIGURES

A fuller explanation of the invention is given in the description of the invention below, based on the acompanying figures in which:
- figure 1 is a block diagram of the device in accordance with the invention,
- figure 2 shows how the magnetic field sensor head is formed as it is used in the device object of the invention.

### DESCRIPTION OF THE INVENTION

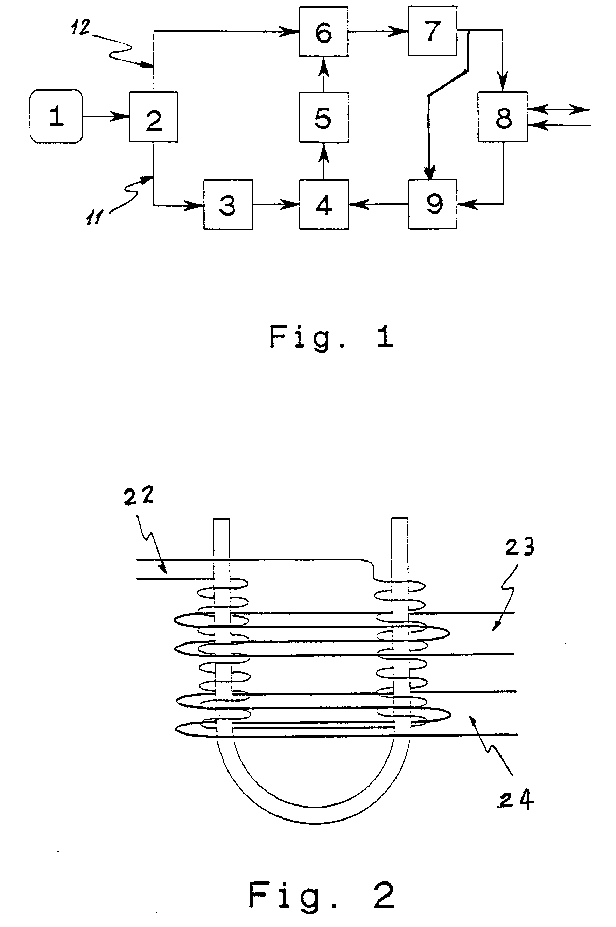

The magnetic field sensor device based on the flux-gate principle, in accordance with the invention, is based on the block diagram of figure 1 in which there is a master oscillator 1 from which is obtained a signal with a stable frequency that is applied to a frequency generator 2 that generates a first 11 and a second 12 signals of frequencies fₒ and 2fₒ, respectively.

The first signal 11 with frequency fₒ, coming from the frequency generator 2, is amplified in a power booster 3 with a current mode output, in order to feed the magnetising coil 22 of the sensor head 4.

The signal coming from the sensor coil 23 of this sensor head 4 is filtered in a first bandpass filter 5 (designed using switched capacity technique and employing the master oscillator so that, in the event of a variation in its central frequency, the latter is always the same as the frequency that has to be filtered) in order to obtain the second harmonic of the frequency, 2fₒ.

There is also a phase detector 6 that receives the second signal 12 with frequency 2fₒ coming from the frequency generator 2 and the signal coming from the first bandpass filter 5. The output of the phase detector 6 has a direct current component the amplitude of which is proportional to that of the output from the first bandpass filter 5, and a double frequency component (4fₒ) that is suppressed in a second bandpass filter 7.

The phase detector 6 consists, in turn, of a phase shifter, that is a digital delay circuit the clock for which is also obtained from the master oscillator 1, and a multiplier circuit

Finally the output signal from the second lowpass filter 7 is applied, on one hand, to a communications block 8 that transmits it, after being suitably adapted for the communications channel, to the remote station and, on the other hand, to a self-calibration block 9 that generates a current proportional to the output signal of the second lowpass filter 7 and that feeds a compensating coil 24, thereby closing a loop that cancels the magnetic field inside the sensor core.

The self-calibration block 9 is activated remotely by means of a control command through the communications block 8, it also being possible, by means of a control command, to increase the current in the compensating coil by a defined amount so that an output signal is obtained for checking the proper operation of the device.

The complete set of characteristics of this device permits it to work correctly within a very wide temperature range, as well as to have the purely electronic part close to the sensor head, thanks to the self-calibration function, and additionally permits it to be compact and reduced in size. As a result, it is of application in locations where temperatures are extreme and with low maintenance, such as is the case of ground aircraft traffic control in airports.

## Claims

1. **MAGNETIC FIELD SENSOR DEVICE** based on flux-gate technology and detection of the second harmonic which comprises a frequency generator (2) that generates first (11) and second (12) signals with frequencies fₒ and 2fₒ respectively, starting from a master oscillator (1) producing a highly stable frequency, in which the first signal (11) is amplified in a power booster (3) before being subsequently applied to the magnetising coil (22) of the sensor head (4); in which the signal coming from the sensor coil (23) of this sensor head (4) is passed through a first bandpass filter (5) with central frequency 2fₒ to filter out its second harmonic that is applied to a phase detector (6) along with the second signal (12) coming from the frequency generator (2); and in which the output of this phase detector (6) is filtered in a second lowpass filter (7), the amplitude of the output signal of this second lowpass filter (7) being proportional to the magnetic field present in the sensor head from an external source and **characterised** in that the transfer functions of the filters employed in this device are made to depend on the same reference frequency as do the first (11) and second (12) signals produced by the frequency generator (2).

2. **DEVICE** according to claim 1, **characterized** in that the magnetising (22) and compensating (24) coils are fed in current mode such that possible variations in the self-inductances cannot affect phase changes in the signals prior to the phase detector (6).

3. **DEVICE** according to claim 1, **characterised** in that the filters that are used are of the switched capacitance type in which the working frequency is also obtained from the same master oscillator (1) that produces the first (11) and second (12) signals coming from the frequency generator (2).

4. **DEVICE** according to claim 3, **characterized** in that the phase detector (6) consists of elements to perform the multiplication of the signal coming from the first bandpass filter (5), of central frequency 2fₒ, with the second signal (12) coming from the frequency generator (2), which has a symmetric square waveform and which in addition has been suitably shifted in phase in a phase shifter to make it coincide in phase with the signal coming from the first bandpass filter (5).

5. **DEVICE** according to claim 4, **characterised** in that the phase shifter is designed as a digital delay circuit for a whole number of clock periods and a multiple of the frequency 2fₒ generated from the same master oscillator (1) that is used by the frequency generator (2).

6. **DEVICE** according to claim 1, **characterised** in that it also includes:
- a self-calibration block (9) connected to the output of the second bandpass filter (7) that generates a signal to feed the compensating coil (24) of the sensor head (4), and which is proportional and in the opposite sense to the signal coming from the second lowpass filter (7) in order to cancel out the magnetic field present in the core of the sensor head (4), and
- a communications block (8) connected to the output of the second lowpass filter (7) to transmit the signal obtained by the sensor to a remote point.

7. **DEVICE** according to claim 6, **characterised** in that the self-calibration block (9) also receives, through the communications block (8), commands from a remote point to cancel the magnetic field from an external source present in the core, and to apply a determined direct current signal to the compensating coil (24), which will produce another output voltage from the sensor, the value of which serves to check the correct operation of the sensor device.

8. **DEVICE** according to claim 6, **characterised** in that the communications block (8) also receives a supply signal from a remote point for powering this device.

9. **DEVICE** according to claim 6, **characterised** in that the electronic part of the device is physically located close to the sensor head because to the magnetic field self-cancelling characteristic, permitting a small size and compactness.

10. **DEVICE** according to any of the above claims, **characterised** by its use in the ground traffic control of aircraft when a set of these devices are installed and distributed along the course of the runways and are coordinated by a central control station.
